# EUROPÄISCHE PATENTSCHRIFT

(11) **EP 2 802 819 B1**
(45) Veröffentlichungstag und Bekanntmachung des Hinweises auf die Patenterteilung: **11.03.2020**
(21) Anmeldenummer: 12810237.3
(22) Anmeldetag: 19.12.2012
(51) Int. Cl.: F24C 15/10, F24C 7/08, H03K 17/96

(54) **KOCHFELD**
COOKING HOB
PLAQUE DE CUISSON

(30) Priorität: 11.01.2012 DE 102012200292
(43) Veröffentlichungstag der Anmeldung: 19.11.2014
(73) Patentinhaber: BSH Hausgeräte GmbH, 81739 München (DE)
(72) Erfinder: MARBACH, Andreas, 83374 Traunwalchen (DE); SCHMAL, Stefan, 84101 Obersüßbach (DE); WURNITSCH, Ernst, 6382 Kirchdorf in Tirol (AT)
(86) Internationale Anmeldenummer: PCT/EP2012/076154
(87) Internationale Veröffentlichungsnummer: WO 2013/104501

(56) Entgegenhaltungen:
- EP-A1- 0 994 306
- EP-A1- 1 602 882
- DE-A1- 10 052 585
- DE-A1-102006 007 169
- DE-A1-102007 029 174
- DE-A1-102009 000 383
- DE-A1-102009 000 383
- DE-U1- 20 207 052
- DE-U1- 29 712 427
- JP-A- 2005 055 041

## Beschreibung

Die Erfindung betrifft ein Kochfeld mit einer Bedieneinrichtung mit einer Bedienelementaufnahme und einem Bedienelement, welches auf der Bedienelementaufnahme positionierbar ist und relativ dazu bewegbar ist, um Betriebsbedingungseinstellungen des Kochfelds bewirken zu können.

Bedieneinrichtungen für Haushaltsgeräte sind in vielfältiger Ausgestaltung bekannt. In diesem Zusammenhang sind Ausgestaltungen mit einem Bedienelement bekannt, welches zerstörungsfrei lösbar von einer Bedienelementaufnahme abnehmbar und wieder anbringbar ist. Derartige Bedienelemente werden über magnetische Haltekräfte auf der Bedienelementaufnahme gehalten. Ein dazu bekanntes Bedienelement ist scheibenförmig oder diskusförmig ausgestaltet. In diesem Zusammenhang sind Bedieneinrichtungen für Kochfelder bekannt. Das Bedienelement kann dabei derart ausgestaltet werden, dass es lediglich drehbar ist, wobei durch eine spezifische Drehstellung eine Kochstufe einer ausgewählten Kochzone einstellbar ist. Das Auswählen der Kochzone wird bei dieser Ausgestaltung des Bedienelements durch ein Verschieben in der horizontalen Ebene auf der Bedienelementaufnahme bewirkt.

Darüber hinaus sind Bedieneinrichtungen bekannt, bei denen ein derartiges Bedienelement im Unterschied zur vorhergehenden Ausführung gekippt werden kann, wobei durch eine spezifische Kippstellung die Auswahl einer Kochzone erfolgt. Ebenso kann dann durch ein Drehen die Kochstufe dieser ausgewählten Kochzone eingestellt werden.

Bei beiden Ausgestaltungen ist vorgesehen, dass die jeweilige Relativposition des Bedienelements zur Bedienelementaufnahme durch Hall-Sensoren detektiert werden. Dazu sind in dem Bedienelement neben dem zentralen Haltemagneten weitere Detektionsmagnete angeordnet, wobei dann in Wechselwirkung mit den Hall-Sensoren die Positionsdetektion erfolgt.

Derartige Bedieneinrichtungen sind relativ komplex aufgebaut und es ist zwingend erforderlich, das Bedienelement zu bewegen, um eine Auswahl einer Kochzone durchführen zu können.

Es offenbart die DE 10 2009 000 383 A1 eine Bedienvorrichtung eines Haushaltsgeräts.

Ferner offenbart die DE 10 2006 007 169 eine Vorrichtung und ein Verfahren zum Betrieben eines Elektrogerätes mit einer außen ansetzbaren Bedieneinrichtung.

Die DE 297 12 427 U1 offenbart eine Einschalteindeutigkeit für Kochfelder.

Die EP 1 602 882 A1 offenbart eine IR-Sensoranordnung für eine pseudo-kontinuierliche Bedienung.

Die EP 0 994 306 A1 offenbart eine Bedieneinrichtung eines Gasbrenners durch Nachführen nach einem Finger eines Nutzers.

Die JP 2005-055041 A offenbart ein Kochfeld und ein Montageverfahren für ein Halteelement eines optischen Teils im Kochfeld.

Es ist Aufgabe der vorliegenden Erfindung, ein Kochfeld mit einer derartigen Bedienvorrichtung zu schaffen, bei welcher bzw. bei welchem eine detektionssichere und nutzerfreundliche Bedienung gegeben ist.

Diese Aufgabe wird durch ein Kochfeld gemäß dem unabhängigen Anspruch gelöst. Eine Bedienvorrichtung des erfindungsgemäßen Kochfelds umfasst ein Bedienelement, welches auf einer Bedienelementaufnahme abnehmbar positionierbar ist. Das Bedienelement umfasst zumindest einen Berührbereich, durch dessen Berühren eine Betriebsbedingung des Haushaltsgerät einstellbar ist. Die Bedieneinrichtung umfasst eine IR-Sende-Empfangseinheit, mit welcher IR (Infrarot-Strahlung) zum Berührbereich aussendbar ist und das Berühren des Berührbereichs durch die von dort reflektierte IR-Strahlung detektierbar ist. Durch eine derartige Ausgestaltung ist eine Bedienvorrichtung geschaffen, die mit hoher Präzision das Detektieren an einem spezifischen Berührbereich ermöglicht. Auch dann, wenn eine Vielzahl von derartigen Berührbereichen klein und/oder darüber hinaus auch noch relativ nah benachbart zueinander angeordnet sind, ist durch diese Ausgestaltung mit der IR-Sende-Empfangseinheit eine hohe Präzision in der Detektion erreicht. Darüber hinaus wird durch die IR-Sende-Empfangseinheit auch eine optische Ausgestaltung geschaffen, die im für den Menschen nicht sichtbaren Spektralbereich eine Berührungsdetektion ermöglicht. Unerwünschte Beeinflussung des Nutzers durch sichtbare Lichter betreffend die optische Detektion als solche können dadurch vermieden werden. Darüber hinaus ist es nicht mehr erforderlich, das Bedienelement tatsächlich zu bewegen, um eine Betriebsbedingungseinstellung durchführen zu können.

Es ist vorgesehen, dass das Bedienelement eine Kappe bzw. einen Deckel aufweist, welche bzw. welcher bereichsweise für IR-Strahlung durchlässig ist.

Ferner ist vorgesehen, dass die IR-Sende-Empfangseinheit bedienelementextern angeordnet ist.

Weiterhin ist vorgesehen, dass die IR-Sende-Empfangseinheit unter der Bedienelementaufnahme angeordnet ist. Dort ist sie geschützt positioniert.

Vorzugsweise ist vorgesehen, dass der Berührbereich auf einer Oberseite und/oder einer Seitenwand des Bedienelements ausgebildet ist. Die leicht erkennbare und sehr zielgenaue Berührung ist dadurch möglich.

Vorzugsweise ist vorgesehen, dass ein Berührbereich als radialer geradliniger Streifen oder als Ring oder als eckenfrei oder eckige Flächenausgestaltung ausgebildet ist. Dadurch können formspezifisch ganz individuelle Berührbereiche geschaffen werden, die gegebenenfalls auch durch ihre geometrische Ausgestaltung individualisierbar sind. Das erleichtert dem Nutzer die Erkennbarkeit und die Unterscheidungsmöglichkeit.

Vorzugsweise ist vorgesehen, dass das Bedienelement einen als Kappe ausgebildeten Deckel und einen Boden aufweist, und ein zwischen dem Deckel und dem Boden gebildeter Hohlraum mit einer IR-Strahlung durchlässigen Füllmasse bzw. Füllmaterial gefüllt ist. Die Leitbarkeit der IR-Strahlung wird dadurch wesentlich verbessert.

Vorzugsweise ist vorgesehen, dass ein Boden des Bedienelements einen Auflagebereich aufweist, mit welchem er auf der Bedienelementaufnahme aufsitzt, wobei der Auflagebereich für IR-Strahlung durchlässig ist. Dieser Auflagebereich bzw. die Lauffläche ist somit insbesondere direkt mit der Oberseite der Bedienelementaufnahme kontaktiert.

Vorzugsweise ist vorgesehen, dass ein Sendeelement bzw. ein IR-Sender der IR-Sende-Empfangseinheit in einem ersten Ring bzw. einem ersten radialen Abstand zu einem Mittelpunkt angeordnet ist und ein Empfangselement bzw. ein IR-Empfänger der IR-Sende-Empfangseinheit in einem zum ersten Ring mit unterschiedlichem Radius ausgebildeten zweiten Ring angeordnet ist, insbesondere in Verlängerung der Radiuslinie, zwischen dem Mittelpunkt und dem IR-Sender weiter außen angeordnet ist.

Vorzugsweise ist vorgesehen, dass eine Mehrzahl von Berührbereichen in Umlaufrichtung um eine Längsachse des Bedienelements, insbesondere beabstandet und äquidistant ausgebildet sind.

Insbesondere ist vorgesehen, dass jeweils ein Berührbereich einem IR-Sender und einem IR-Empfänger zugeordnet ist und der Berührbereich in Richtung der Längsachse über diesem Sender und dem Empfänger angeordnet und ausgebildet ist. Vorzugsweise ist vorgesehen, dass mehreren Berührbereichen jeweils eine Funktionsteileinheit des Haushaltsgerät zugeordnet ist und mit dem Berühren und dem Erkennen des Berührens die zugehörige Funktionsteileinheit ausgewählt ist. So kann insbesondere bei einem Kochfeld vorgesehen sein, dass jeweils ein Berührbereich zur Auswahl einer Kochzone ausgebildet und berührbar ist. Die Funktionsteileinheit ist dann die Kochzone.

Vorzugsweise ist vorgesehen, dass das Bedienelement scheibenförmig oder diskusförmig ausgebildet ist. Insbesondere umfasst die Bedienvorrichtung nur ein einziges derartiges Bedienelement, welches zerstörungsfrei reversibel von der Bedienelementaufnahme abnehmbar und wieder aufsetzbar ist.

Vorzugsweise umfasst das Bedienelement zumindest einen Lichtaustrittsbereich, über den Licht im für den Menschen sichtbaren Spektralbereich, insbesondere von der Oberseite des Bedienelements, emittierbar ist. Hierzu kann vorgesehen sein, dass das Bedienelement zumindest einen Lichtleiter aufweist, von dem bzw. mit dem eingekoppeltes Licht an dem Lichtaustrittsbereich emittierbar ist. Vorzugsweise ist der Lichtleiter so gestaltet, dass er sich durch die gesamte Höhe des Bedienelements erstreckt und am Boden des Bedienelements Licht in den Lichtleiter einkoppelbar ist, welches dann an dem Lichtaustrittsbereich wieder emittierbar ist. Der Lichtleiter kann beispielsweise als Hohlzylinder ausgebildet sein.

Es kann vorgesehen sein, dass der Lichtaustrittsbereich ein Ringabschnitt oder ein geschlossener Ring ist. Es können jedoch auch beliebige andere Flächenformen des Lichtaustrittsbereichs ausgebildet sein, beispielsweise eine eckenfreie Flächenform oder eine eckige Flächenform. Lichtquellen sind insbesondere Bedienelementextern angeordnet, beispielsweise unter der Bedienelementaufnahme auf einem Schaltungsträger positioniert. Als Lichtquellen können beispielsweise Leuchtdioden oder Laserdioden vorgesehen sein. Es kann hier vorgesehen sein, dass zumindest eine erste Lichtquelle zur Emission von nur einer Lichtfarbe ausgebildet ist und zumindest eine weitere Lichtquelle zur Emission von Licht einer zur ersten unterschiedlichen zweiten Lichtfarbe ausgebildet ist. Es kann auch vorgesehen sein, dass zumindest eine Lichtquelle zur Erzeugung von Licht einer ersten Lichtfarbe und Licht einer zweiten Lichtfarbe ausgebildet ist. Beispielsweise kann eine Lichtquelle eine RGB (Rot-Gelb-Blau) -Leuchtdiode sein. Es kann vorgesehen sein, dass in einer Reihenfolge die ersten und die weiteren Lichtquellen alternierend zueinander angeordnet und positioniert sind.

Weitere Merkmale ergeben sich aus den Ansprüchen, den Figuren und der Figurenbeschreibung.

Ausführungsbeispiele der Erfindung werden nachfolgend anhand schematischer Zeichnungen näher erläutert. Es zeigen:
- Fig. 1: eine schematische perspektivische Darstellung eines erfindungsgemäßen Kochfelds;
- Fig. 2: eine Schnittdarstellung durch ein erstes Ausführungsbeispiel einer Bedieneinrichtung;
- Fig. 3: eine Draufsicht auf die Ausgestaltung gemäß Fig. 2;
- Fig. 4: eine Draufsicht auf ein weiteres Ausführungsbeispiel einer Bedieneinrichtung;
- Fig. 5: eine nochmalige Draufsicht auf ein weiteres Ausführungsbeispiel einer Bedieneinrichtung;
- Fig. 6: eine Schnittdarstellung durch ein weiteres Ausführungsbeispiel einer erfindungsgemäßen Bedieneinrichtung gemäß Fig. 4;
- Fig. 7: eine Schnittdarstellung durch ein weiteres Ausführungsbeispiel einer erfindungsgemäßen Bedieneinrichtung; und
- Fig. 8: eine Draufsicht auf die Bedieneinrichtung gemäß Fig. 7.

In den Figuren werden gleiche oder funktionsgleiche Elemente mit den gleichen Bezugszeichen versehen.

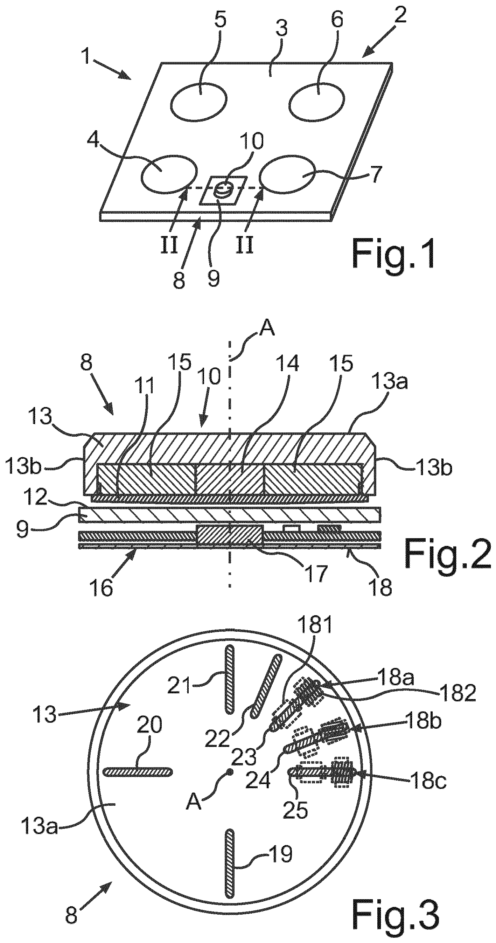

In Fig. 1 ist in einer schematischen perspektivischen Darstellung ein als Kochfeld 1 ausgebildetes Haushaltsgerät gezeigt. Das Kochfeld 1 umfasst eine Kochfeldplatte 2, welche aus Glas oder Glaskeramik ausgebildet sein kann. Auf einer Oberseite 3 der Kochfeldplatte 2 sind in Anzahl und Position lediglich beispielhaft vier Kochzonen 4, 5, 6 und 7 gekennzeichnet. Auf diesen können Zubereitungsgefäße aufgestellt werden und sie können über unter der Kochfeldplatte 2 angeordnete Heizeinheiten beheizt werden.

Darüber hinaus umfasst das Kochfeld 1 eine Bedienvorrichtung 8, welche eine Bedienelementaufnahme 9 aufweist. Darüber hinaus umfasst die Bedienvorrichtung 8 ein Bedienelement 10. Im Ausführungsbeispiel ist die Bedienvorrichtung 8 in der Kochfeldplatte 2 ausgebildet. Sie kann auch benachbart zu der Kochfeldplatte 2 beispielsweise in einer Arbeitsplatte ausgebildet sein.

Im Ausführungsbeispiel ist vorgesehen, dass die Bedienvorrichtung 8 nur dieses eine einzige Bedienelement 10 aufweist, mittels welchem die Auswahl der Kochzonen 4 bis 7 als auch die Einstellung der Kochstufen dieser Kochzonen 4 bis 7 ermöglicht. Es kann auch vorgesehen sein, dass weitere Funktionen, wie beispielsweise eine Timerfunktion und/oder eine Wischschutzfunktion und/oder eine Warmhaltefunktion und/oder eine Boostfunktion mit dem Bedienelement 10 eingestellt werden können. Es kann jedoch auch vorgesehen sein, dass für die zuletzt genannten Funktionen beispielsweise ein berührsensitives Bedienfeld ausgebildet ist, welches entsprechende Bedienstellen aufweist, um die genannten Funktionen auswählen und einstellen zu können.

Das Bedienelement 10 ist scheibenförmig oder diskusförmig ausgestaltet und zerstörungsfrei reversibel von der Bedienelementaufnahme 9 abnehmbar und wieder aufsetzbar. Nur im darauf positionierten Zustand können Betriebsbedingungen eingestellt werden.

In Fig. 2 ist eine Schnittdarstellung durch ein erstes Ausführungsbeispiel einer Bedienvorrichtung 8 entlang der Schnittlinie II-II in Fig. 1 gezeigt. In der gezeigten Ausführung ist das Bedienelement 10 auf der Bedienelementaufnahme 9 positioniert. Es ist hierbei zu erwähnen, dass die Bedienelementaufnahme 9 als separates Bauteil ausgebildet ist und in Form eines Einlegers in eine Aussparung der Kochfeldplatte 2 eingesetzt ist. Es kann jedoch auch vorgesehen sein, dass die Bedienelementaufnahme 9 integral in der Kochfeldplatte 2 ausgebildet ist und beispielsweise Bestandteil der Kochfeldplatte 2 ist. Insbesondere bei einer derartigen Ausgestaltung kann die Bedienelementaufnahme 9 aus dem gleichen Material wie die Kochfeldplatte 2 ausgebildet sein, beispielsweise aus Glas oder Glaskeramik.

In der gezeigten Ausführung gemäß Fig. 2 ist das Bedienelement 10 mit einem Boden 11, der beispielsweise aus Kunststoff ausgebildet ist, auf einer Oberseite 12 der Bedienelementaufnahme 9 positioniert.

Wie aus der Darstellung in Fig. 2 zu erkennen ist, umfasst das Bedienelement 10 eine Kappe bzw. einen Deckel 13, der das Bedienelement 10 von oben und im wesentlichen vollständig seitlich abdeckt. Der Deckel 13 ist mit dem Boden 11 verbunden und dazwischen ist ein Hohlraum ausgebildet, in dem ein bedienelementseitiger Zentralmagnet 14 angeordnet ist. Im Ausführungsbeispiel ist vorgesehen, dass der weitere Hohlraum durch ein Füllmaterial 15 gefüllt ist, wobei dieses Füllmaterial 15 durchlässig für Infrarotstrahlung (IR-Strahlung) ist.

Darüber hinaus umfasst die Bedienvorrichtung 8 einen elektronischen Schaltungsträger 16, der unter der Bedienelementaufnahme 9 angeordnet ist. Unter dieser Bedienelementaufnahme 9 ist auch ein bedienelementexterner Zentralmagnet 17 angeordnet, welcher in magnetischer Wechselwirkung mit dem bedienelementseitigen Zentralmagneten 14 die magnetische Haltekraft für das Bedienelement 10 bewirkt. Diese beiden Zentralmagnete 14 und 17 stellen daher die Haltemagnete dar.

Auf dem Schaltungsträger 16 sind elektronische Bauteile angeordnet. Insbesondere ist auf diesem Schaltungsträger 16 im Ausführungsbeispiel eine Mehrzahl von IR-Sende-Empfangseinheiten angeordnet.

Mittels einer IR-Sende-Empfangseinheit wird Infrarotstrahlung durch die Bedienelementaufnahme 9, den Boden 11, das Füllmaterial 15 und Aussparungen die jeweils einem Berührbereich zugehörig sind und in dem Deckel 13 ausgebildet sind, hindurchgestrahlt, sodass diese Strahlung über diese Aussparungen bzw. Licht durchlässigen Stellen im Deckel 13 austreten kann. Wird an einer spezifischen Aussparung das Bedienelement 10 von einem Nutzer mit beispielsweise einem Finger berührt, so wird die Infrarotstrahlung wieder reflektiert und gelangt dann über den entsprechenden Rückweg zur Sende-Empfangseinheit zurück. Durch Detektion einer derartigen reflektierten Infrarotstrahlung kann dann die zugeordnete Betriebsbedingungseinstellung aktiviert und durchgeführt werden.

In Fig. 3 ist eine Draufsicht auf die Bedienvorrichtung 8 gemäß Fig. 2 gezeigt. Es ist zu erkennen, dass auf einer Oberseite 13a des Deckels 13 mehrere schlitzartige bzw. streifenförmige Berührbereiche 19, 20, 21, 22, 23, 24 und 25 ausgebildet sind. Diese sind in radialer Richtung gradlinig orientiert. Durch Berühren der Oberseite 13a an der Stelle einer der Berührbereiche 19 bis 25 wird eine entsprechende gewünschte Betriebsbedingungseinstellung hervorgerufen.

Wie aus der Darstellung in Fig. 3 des Weiteren zu erkennen ist, sind beispielhaft drei Sende-Empfangseinheiten 18a, 18b und 18c dargestellt, die direkt in Richtung der Längsachse A des Bedienelements 10 betrachtet unter den Berührbereiche 23 bis 25 mit den jeweiligen Aussparungen angeordnet sind.

Darüber hinaus ist zu erkennen, dass die IR-Sende-Empfangseinheiten jeweils mit einem Sender und einem Empfänger ausgebildet sind. Im Ausführungsbeispiel ist vorgesehen, dass die IR-Sender in radialer Richtung betrachtet weiter innen liegend angeordnet sind, als die radial nach außen jeweils benachbart dazu angeordneten IR-Empfänger.

In Fig. 3 sind die Berührbereiche 19 bis 25 in Form und Größe gleich ausgestaltet.

Es kann jedoch auch vorgesehen sein, dass zumindest zwei Berührbereiche unterschiedliche Form und/oder Größe aufweisen.

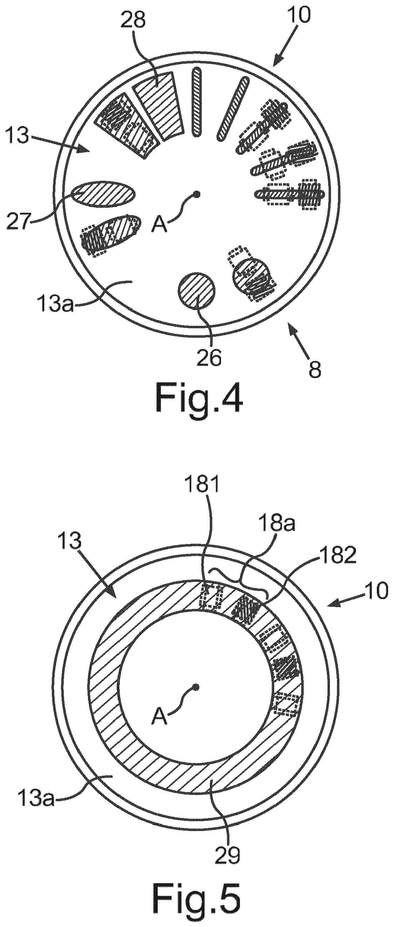

In Fig. 4 ist eine Draufsicht auf ein weiteres Ausführungsbeispiel einer Bedienvorrichtung 8 gezeigt, wobei hier auf der Oberseite 13 beispielhaft mehrere unterschiedliche Formen von Berührbereiche gezeigt sind. Neben den bereits in Fig. 3 gezeigten und erläuterten schlitzartigen Berührbereiche können hier auch kreisrunde Berührbereiche 26, ovale Berührbereiche 27 oder Kuchenstückartige Berührbereiche 28 vorgesehen sein. Auch hier ist jeweils vorgesehen, dass unter den Berührbereiche entsprechende IR-Sende-Empfangseinheiten mit entsprechend angeordneten IR-Sendern und IR-Empfängern ausgebildet sind.

In Fig. 5 ist ein weiteres Ausführungsbeispiel einer Bedienvorrichtung 8 in Draufsicht gezeigt, wobei hier zu erkennen ist, dass ein Berührbereich 29 auf einer Oberseite 13a des Deckels 13 als Ring gestaltet ist. Bei dieser Ausgestaltung ist darüber hinaus auch vorgesehen, dass eine IR-Sende-Empfangseinheit 18a mit einem IR-Sender 181 und einem IR-Empfänger 18 nicht in radialer Richtung nach außen folgend angeordnet sind, sondern in Umlaufrichtung um die Achse A nebeneinander positioniert sind. Entsprechendes ist für die IR-Sender und IR-Empfänger der weiteren IR-Sende-Empfangseinheiten vorgesehen.

Wesentlich ist auch hier, dass der gesamte Weg von einem IR-Sender 181 bis zur Oberseite 13a und von dieser wieder zurück zu einem IR-Empfänger 182 für Infrarotstrahlung durchlässig ist.

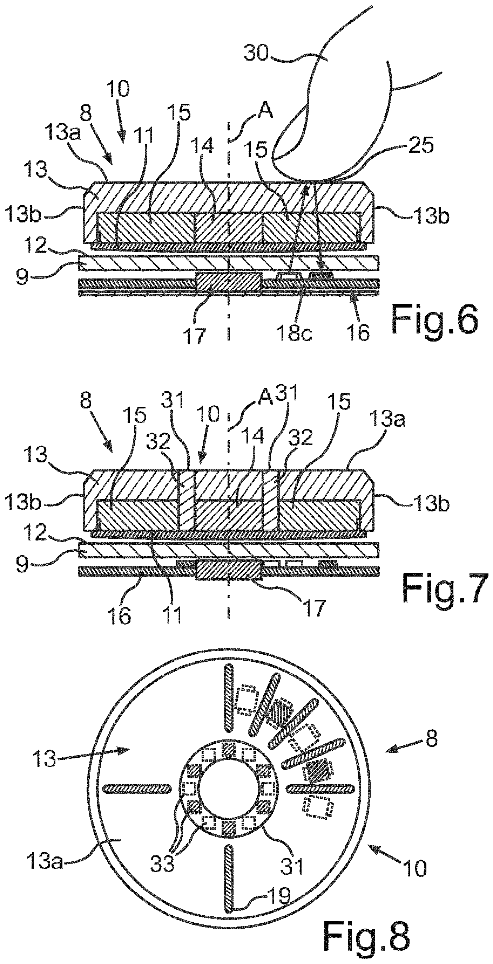

In Fig. 6 ist die Ausgestaltung gemäß Fig. 2 und Fig. 3 gezeigt, wobei hier auf dem Berührbereich 25 ein Finger 30 aufgelegt ist. Im Ausführungsbeispiel wird dadurch eine Kochzone 4 bis 7 ausgewählt. Nach dieser Auswahl kann dann durch Drehen des Bedienelements 10 um die Achse A eine Kochstufe dieser ausgewählten Kochzone 4 bis 7 eingestellt werden.

Dazu ist gemäß der Darstellung in Fig. 6 auch der Strahlengang der Infrarotstrahlung von dem IR-Sender der IR-Sende-Empfangseinheit 18c zur Aussparung 25 und die von dem Finger 30 reflektierte Infrarotstrahlung zu dem IR-Empfänger gezeigt.

In Fig. 7 ist ein weiteres Beispiel einer Bedienvorrichtung 8 im Querschnitt gezeigt. Bei dieser Ausgestaltung ist im Unterschied zu den bisherigen Ausgestaltungen zusätzlich noch vorgesehen, dass das Bedienelement 8 Lichtaustrittsbereiche aufweist, die im Ausführungsbeispiel an der Oberseite 13a des Deckels 13 gestaltet sind. Über diese Lichtaustrittsbereiche 31 kann Licht im für den Menschen sichtbaren Spektralbereich emittiert werden.

Im Ausführungsbeispiel ist vorgesehen, dass gemäß der Draufsichtdarstellung in Fig. 8 dieser Lichtaustrittsbereich ein zusammenhängender Ring ist.

Darüber hinaus ist dies derart gestaltet, dass im Bedienelement 10 ein Lichtleiter 32 angeordnet ist, der sich über die gesamte Höhe des Bedienelements 10 erstreckt. Es ist darüber hinaus vorgesehen, dass auf dem Schaltungsträger 16 mehrere Lichtquellen, beispielsweise Leuchtdioden angeordnet sind, deren Licht durch die Bedienelementaufnahme 9 hindurchstrahlbar ist und dann in den Lichtleiter 32 bodenseitig einkoppelbar ist und dann deckelseitig über den Lichtaustrittsbereich 31 abstrahlbar ist.

Wie aus der Darstellung in Fig. 8 zu erkennen ist, sind die Lichtquellen 33, von denen nur einige beispielhaft mit den entsprechenden Bezugszeichen versehen sind, direkt unterhalb des Lichtleiters 32 angeordnet. Es kann vorgesehen sein, dass die Lichtquellen 33 in Umlaufrichtung betrachtet alternierend jeweils zur Emission einer ersten Lichtfarbe und zur Emission einer zweiten Lichtfarbe ausgebildet sind. Dies bedeutet, dass beispielsweise eine erste Lichtquelle zur Emission von Licht einer ersten Lichtfarbe ausgebildet ist und die in Umlaufrichtung jeweils benachbarten Lichtquellen zur Emission von Licht einer dazu unterschiedlichen zweiten Lichtfarbe ausgebildet sind.

Darüber hinaus ist in Fig. 8 eine Ausführung gezeigt, bei der IR-Sender und IR-Empfänger von IR-Sende-Empfangseinheiten nicht direkt unter entsprechenden Berührbereichen im Deckel 13 angeordnet sind sondern versetzt dazu. Auch durch eine derartige Ausgestaltung ist eine Berührungsdetektion möglich.

Bei allen Ausführungen kann beispielsweise auch vorgesehen sein, dass der Zentralmagnet 14 oder der Zentralmagnet 17 lediglich ein Metallstück ist.

Die Bedienelementaufnahme 9 kann auch beispielsweise aus Kunststoff sein, wesentlich ist, dass zumindest an entsprechenden Stellen der jeweiligen Sende-Empfangseinheiten 18a bis 18c ein für Infrarotstrahlung durchlässiger Bereich ausgebildet ist.

Es kann auch vorgesehen sein, dass die Bedienelementaufnahme 9 eine Vertiefung aufweist, sodass das Bedienelement 10 im aufgesetzten Zustand bereichsweise in dieser Vertiefung versenkt positioniert ist.

Darüber hinaus kann neben den gezeigten Ausführungen auch vorgesehen sein, dass Durchbrüche bzw. Aussparungen von Berührbereichen 19 bis 28 zusätzlich oder anstatt zur Ausbildung auf der Oberseite 13a auch an einer Seitenwand 13b ausgebildet sind. Ebenso kann vorgesehen sein, dass die Kappe bzw. der Deckel 13 eine andere Formgebung und Ausgestaltung aufweisen kann. Insbesondere ist vorgesehen, dass nur an den Berührbereichen 19 bis 28 eine Durchlässigkeit für Infrarotstrahlung gegeben ist, und an den anderen Stellen dies verhindert ist.

Das Füllmaterial 15 kann beispielsweise eingespritzt oder vorgeformt eingebracht sein. Bzgl. der Durchlässigkeit für Infrarotstrahlung durch den Boden 11 des Bedienelements 10 kann hier auch eine entsprechende Segmentierung wie im Deckel 13 vorgesehen sein. Alternativ kann auch nur das IR-durchlässige Material als Lauffläche für den Boden 11 dienen. Es ist auch möglich, dass ein Kunststoffring als Lauffläche verwendet wird. Die Lauffläche ist dabei derjenige Flächenbereich des Bodens 11, mit dem der Boden 11 direkt auf der Oberseite 12 der Bedienelementaufnahme 9 aufliegt.

Zur Auswertung der Infrarotsignale ist auf dem Schaltungsträger 16 eine entsprechende Auswerteelektronik ausgebildet.

Mit der zu Fig. 7 und Fig. 8 erläuterten Ausführung mit einer Beleuchtungseinrichtung können ausgewählte und eingestellte Betriebsbedingungen auch optisch für einen Nutzer kenntlich gemacht werden.

### Bezugszeichenliste

- 1: Kochfeld
- 2: Kochfeldplatte
- 3: Oberseite
- 4: Kochzone
- 5: Kochzone
- 6: Kochzone
- 7: Kochzone
- 8: Bedienvorrichtung
- 9: Bedienelementaufnahme
- 10: Bedienelement
- 11: Boden
- 12: Oberseite
- 13: Deckel
- 14: Zentralmagnet
- 15: Füllmaterial
- 16: Schaltungsträger
- 17: Zentralmagnet
- 18, 18a, 18b, 18c: IR-Sende-Empfangseinheit
- 19: Berührbereich
- 20: Berührbereich
- 21: Berührbereich
- 22: Berührbereich
- 23: Berührbereich
- 24: Berührbereich
- 25: Berührbereich
- 26: Berührbereich
- 27: Berührbereich
- 28: Berührbereich
- 29: Berührbereich
- 30: Finger
- 31: Lichtaustrittsbereich
- 32: Lichtleiter
- 33: Lichtquellen
- A: Längsachse

## Patentansprüche

1. Kochfeld (1) mit einer Bedienvorrichtung (8), das eine Bedienelementaufnahme (9) und ein Bedienelement (10) aufweist, welches zumindest einen Berührbereich (19 bis 28) aufweist, durch dessen Berühren eine Betriebsbedingung des Kochfelds (1) einstellbar ist, wobei eine IR-Sende-Empfangseinheit (18, 18a, 18b, 18c) ausgebildet ist, mit welcher IR-Strahlung zum Berührbereich (19 bis 28) aussendbar ist und das Berühren des Berührbereichs (19 bis 28) durch die von dort reflektierte IR-Strahlung detektierbar ist, wobei das Bedienelement (10) auf der Bedienelementaufnahme (9) abnehmbar positionierbar ist, **dadurch gekennzeichnet, dass** die IR-Sende-Empfangseinheit (18, 18a bis 18c) bedienelementextern unter der Bedienelementaufnahme (9) angeordnet ist, und das Bedienelement (10) einen Deckel (13) aufweist, welcher bereichsweise für IR-Strahlung durchlässig ist.

2. Kochfeld (1) nach Anspruch 1, **dadurch gekennzeichnet, dass** der Berührbereich (19 bis 28) auf einer Oberseite (13a) und/oder einer Seitenwand (13b) des Bedienelements (10) ausgebildet ist.

3. Kochfeld (1) nach einem der vorhergehenden Ansprüche, **dadurch gekennzeichnet, dass** ein Berührbereich (19 bis 28) als radialer geradliniger Streifen oder als Ring oder als eckenfreier oder eckiger Flächenbereich ausgebildet ist.

4. Kochfeld (1) nach einem der vorhergehenden Ansprüche, **dadurch gekennzeichnet, dass** das Bedienelement (10) einen als Kappe ausgebildeten Deckel (13) und einen Boden (11) aufweist, und ein zwischen dem Deckel (13) und dem Boden (11) gebildeter Hohlraum mit einem IR-Strahlung durchlässigen Füllmaterial (15) gefüllt ist.

5. Kochfeld (1) nach einem der vorhergehenden Ansprüche, **dadurch gekennzeichnet, dass** ein Boden (11) des Bedienelements (10) einen Auflagebereich aufweist, mit welchem er auf einer Bedienelementaufnahme (9) aufsitzt, wobei zumindest der Auflagebereich für IR-Strahlung durchlässig ist.

6. Kochfeld (1) nach einem der vorhergehenden Ansprüche, **dadurch gekennzeichnet, dass** ein IR-Sender (181) der IR-Sende-Empfangseinheit (18, 18a bis 18c) in einem ersten Ring zu einem Mittelpunkt und ein IR-Empfänger (182) der IR-Sende-Empfangseinheit (18, 18a bis 18c) in einem zum ersten Ring mit unterschiedlichem Radius ausgebildeten zweiten Ring oder auch in dem ersten Ring angeordnet sind.

7. Kochfeld (1) nach einem der vorhergehenden Ansprüche, **dadurch gekennzeichnet, dass** eine Mehrzahl von Berührbereichen (19 bis 28) in Umlaufrichtung um eine Längsachse (A) des Bedienelements (10), insbesondere beabstandet und äquidistant, ausgebildet sind.

8. Kochfeld (1) nach Anspruch 6 und 7, **dadurch gekennzeichnet, dass** jeweils ein Berührbereich (19 bis 28) einem IR-Sender (181) und einem IR-Empfänger (182) zugeordnet ist und der Berührbereich (19 bis 28) in Richtung der Längsachse (A) über dem IR-Sender (181) und dem IR-Empfänger (182) angeordnet ist.

9. Kochfeld (1) nach einem der vorhergehenden Ansprüche, **dadurch gekennzeichnet, dass** mehreren Berührbereichen (19 bis 28) jeweils eine Funktionsteileinheit (4 bis 7) des Haushaltsgeräts (1) zugeordnet ist und mit dem Berühren und dem Erkennen des Berührens die zugehörige Funktionsteileinheit (4 bis 7) ausgewählt ist.

10. Kochfeld (1) nach einem der vorhergehenden Ansprüche, **dadurch gekennzeichnet, dass** das Bedienelement (10) scheibenförmig oder diskusförmig ausgebildet ist.

11. Kochfeld (1) nach einem der vorhergehenden Ansprüche, **dadurch gekennzeichnet, dass** das Bedienelement (10) zumindest einen Lichtaustrittsbereich (31) aufweist, über den Licht, insbesondere von der Oberseite (13a) des Bedienelements (10), emittierbar ist.

## Claims

1. Cooking hob (1) with a control device (8) which has a control element receptacle (9) and a control element (10), which has at least one touch area (19 to 28), by means of which, when the touching area is touched, an operating condition of the cooking hob (1) can be set, wherein an IR transmit-receive unit (18, 18a, 18b, 18c) is embodied, with which IR radiation can be emitted to the touch area (19 to 28) and the touching of the touch area (19 to 28) can be detected by the IR radiation reflected from there, wherein the control element (10) can be removably positioned on the control element receptacle (9), **characterised in that** the IR transmit-receive unit (18, 18a to 18c) is arranged below the control element receptacle (9) outside of the control element and the control element (10) has a cover (13) which is permeable to IR radiation in areas.

2. Cooking hob (1) according to claim 1, **characterised in that** the touch area (19 to 28) is embodied on a top side (13a) and/or a side wall (13b) of the control element (10).

3. Cooking hob (1) according to one of the preceding claims, **characterised in that** a touch area (19 to 28) is embodied as a radial linear strip or as a ring or as a corner-free or angular surface area.

4. Cooking hob (1) according to one of the preceding claims, **characterised in that** the control element (10) has a cover (13) embodied as a cap and a base (11), and a cavity formed between the cover (13) and the base (11) is filled with a filler material (15) which is permeable to IR radiation.

5. Cooking hob (1) according to one of the preceding claims, **characterised in that** a base (11) of the control element (10) has a contact area, with which it rests on a control element receptacle (9), wherein at least the contact area is permeable to IR radiation.

6. Cooking hob (1) according to one of the preceding claims, **characterised in that** an IR transmitter (181) of the IR transmit-receive unit (18, 18a to 18c) is arranged in a first ring relative to a central point and an IR receiver (182) of the IR transmit-receive unit (18, 18a to 18c) is arranged in a second ring embodied relative to the first ring with a different radius or also in the first ring.

7. Cooking hob (1) according to one of the preceding claims, **characterised in that** a plurality of contact areas (19 to 28) are embodied in the peripheral direction about a longitudinal axis (A) of the control element (10), in particular at a distance and equidistantly.

8. Cooking hob (1) according to claim 6 and 7, **characterised in that** in each case a touch area (19 to 28) is assigned to an IR transmitter (181) and an IR receiver (182) and the touch area (19 to 28) is arranged in the direction of the longitudinal axis (A) above the IR transmitter (181) and the IR receiver (182).

9. Cooking hob (1) according to one of the preceding claims, **characterised in that** in each case one functional subunit (4 to 7) of the household appliance (1) is assigned to a number of touch areas (19 to 28) and the associated functional subunit (4 to 7) is selected by touching, and by the touch being identified.

10. Cooking hob (1) according to one of the preceding claims, **characterised in that** the control element (10) is embodied in the shape of a disc or discus.

11. Cooking hob (1) according to one of the preceding claims, **characterised in that** the control element (10) has at least one light exit area (31), by way of which light can be emitted in particular from the top side (13a) of the control element (10).

## Revendications

1. Table de cuisson (1) comprenant un dispositif de commande (8) qui présente un logement d'élément de commande (9) et un élément de commande (10), lequel présente au moins une zone de contact (19 à 28) au moyen du contact de laquelle une condition de fonctionnement de la table de cuisson (1) est réglable, une unité d'émission-réception à infrarouge (18, 18a, 18b, 18c) étant réalisée, à l'aide de laquelle un rayonnement infrarouge peut être émis vers la zone de contact (19 à 28) et à l'aide de laquelle le contact de la zone de contact (19 à 28) peut être détecté par le rayonnement infrarouge qui y est réfléchi, l'élément de commande (10) étant positionnable de manière amovible sur le logement d'élément de commande (9), **caractérisée en ce que** l'unité d'émission-réception à infrarouge (18, 18a à 18c) est disposée en dessous du logement d'élément de commande (9) de manière externe à l'élément de commande, et **en ce que** l'élément de commande (10) présente un couvercle (13) qui est perméable au rayonnement infrarouge par endroits.

2. Table de cuisson (1) selon la revendication 1, **caractérisée en ce que** la zone de contact (19 à 28) est réalisée sur un côté supérieur (13a) et/ou sur une paroi latérale (13b) de l'élément de commande (10).

3. Table de cuisson (1) selon l'une quelconque des revendications précédentes, **caractérisée en ce qu'**une zone de contact (19 à 28) est réalisée comme bande rectiligne radiale ou comme anneau ou comme zone de surface angulaire ou exempte d'angles.

4. Table de cuisson (1) selon l'une quelconque des revendications précédentes, **caractérisée en ce que** l'élément de commande (10) présente un couvercle (13) réalisé comme capot et un fond (11), et **en ce qu'**un espace creux formé entre le couvercle (13) et le fond (11) est rempli avec une matière de remplissage (15) perméable au rayonnement infrarouge,

5. Table de cuisson (1) selon l'une quelconque des revendications précédentes, **caractérisée en ce qu'**un fond (11) de l'élément de commande (10) présente une zone d'appui à l'aide de laquelle il repose sur un logement d'élément de commande (9), au moins la zone d'appui étant perméable au rayonnement infrarouge.

6. Table de cuisson (1) selon l'une quelconque des revendications précédentes, **caractérisée en ce qu'**un émetteur infrarouge (181) de l'unité d'émission-réception à infrarouge (18, 18a à 18c) est disposé dans un premier anneau par rapport au centre et **en ce qu'**un récepteur infrarouge (182) de l'unité d'émission-réception à infrarouge (18, 18a à 18c) est disposé dans un deuxième anneau, réalisé avec un rayon différent par rapport au premier anneau, ou dans le premier anneau.

7. Table de cuisson (1) selon l'une quelconque des revendications précédentes, **caractérisée en ce qu'**une pluralité de zones de contact (19 à 28) sont réalisées autour d'un axe longitudinal (A) de l'élément de commande (10), notamment à écart et de manière équidistante, dans le sens périphérique.

8. Table de cuisson (1) selon les revendications 6 et 7, **caractérisée en ce que** respectivement une zone de contact (19 à 28) est attribuée à un émetteur infrarouge (181) et à un récepteur infrarouge (182) et **en ce que** la zone de contact (19 à 28) est disposée au-dessus de l'émetteur infrarouge (181) et du récepteur infrarouge (182) en direction de l'axe longitudinal (A).

9. Table de cuisson (1) selon l'une quelconque des revendications précédentes, **caractérisée en ce que** respectivement une unité partielle de fonctionnement (4 à 7) de l'appareil ménager (1) est attribuée à plusieurs zones de contact (19 à 28) et **en ce que** l'unité partielle de fonctionnement (4 à 7) correspondante est sélectionnée par contact et identification du contact.

10. Table de cuisson (1) selon l'une quelconque des revendications précédentes, **caractérisée en ce que** l'élément de commande (10) est réalisé en forme de rondelle ou de disque.

11. Table de cuisson (1) selon l'une quelconque des revendications précédentes, **caractérisée en ce que** l'élément de commande (10) présente au moins une zone de sortie de lumière (31) par l'intermédiaire de laquelle la lumière peut être émise, notamment depuis le côté supérieur (13a) de l'élément de commande (10).
